Europäisches Patentamt

European Patent Office

Office européen des brevets

(11) Veröffentlichungsnummer: **0 198 408 B1**

# (12) EUROPÄISCHE PATENTSCHRIFT

(45) Veröffentlichungstag der Patentschrift: **19.08.92**

(21) Anmeldenummer: **86104836.1**

(22) Anmeldetag: **09.04.86**

(51) Int. Cl.⁵: **H01R 43/16**, H01R 9/09

(54) Werkzeug zur Herstellung eines elektrischen Kontaktstiftes für gedruckte Schaltungsplatten.

(30) Priorität: **17.04.85 DE 3513768**

(43) Veröffentlichungstag der Anmeldung:
**22.10.86 Patentblatt 86/43**

(45) Bekanntmachung des Hinweises auf die
Patenterteilung:
**19.08.92 Patentblatt 92/34**

(84) Benannte Vertragsstaaten:
**DE FR GB**

(56) Entgegenhaltungen:
**EP-A- 0 084 318**
**DE-B- 1 132 614**
**US-A- 3 997 237**

(73) Patentinhaber: **ALCATEL N.V.**
**Strawinskylaan 537 (World Trade Center)**
**NL-1077 XX Amsterdam(NL)**
(84) Benannte Vertragsstaaten:
**FR GB**

(73) Patentinhaber: **Standard Elektrik Lorenz Aktiengesellschaft**
**Lorenzstrasse 10**
**W-7000 Stuttgart 40(DE)**
(84) Benannte Vertragsstaaten:
**DE**

(72) Erfinder: **Mezger, Dieter**
**Nürtinger Strasse 83**
**W-7030 Böblingen(DE)**
Erfinder: **Projer, Josef**
**Kapffstrasse 38**
**W-7068 Urbach(DE)**
Erfinder: **Siewert, Ewald**
**Schönblickstrasse 17**
**W-7132 Illingen 2(DE)**

(74) Vertreter: **Gähr, Hans-Dieter, Dipl.-Ing. (FH) et al**
**Standard Elektrik Lorenz AG Patent- und Lizenzwesen Postfach 30 09 29**
**W-7000 Stuttgart 30(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Beschreibung

Die Erfindung betrifft ein Werkzeug zur Herstellung eines Kontaktstiftes, insbesondere seiner Einpreßzone, mit welcher der Kontaktstift in der durchkontaktierten Bohrung einer gedruckten Schaltungsplatte mit Preßsitz befestigbar ist.

Befestigungsabschnitte von derartigen Kontaktstiften sind in vielfältigen Ausführungen bekannt. In der DE-OS 29 30 560 ist beispielsweise ein zwei federschenkel aufweisender Kontaktstift beschrieben, dessen Einpreßzone durch Spalten seines im Querschnitt quadratischen Schaftes und gleichzeitige Aufweitung mittels zweier Keile hergestellt wird. Beim Aufweiten werden die gespaltenen Schafthälften gegen schalenförmige Widerlager gedrückt, wodurch ihnen jeweils eine gerundete Außenfläche angeprägt wird.

Ein Kontaktstift mit beim Befestigen in einer Bohrung eine bessere Druckverteilung bewirkender Einpreßzone ist aus der US-PS 3 545 080 bekannt. Bei einem Ausführungsbeispiel werden zur Herstellung von drei Federschenkeln mehrere Schlitze und Ausschnitte in ein ebenes Blechteil gestanzt, die so gebildeten Stege zu Federschenkeln durchgebogen und das Blechteil anschließend zu einem hohlen Kontaktstift mit drei im Winkel von 120° zueinander stehenden Federschenkeln aufgerollt. Der Schaft eines derartigen Kontaktstiftes weist jedoch eine für die Wickelanschlußtechnik ungeeignete, kreisrunde Mantelfläche auf.

Aus der EP-A-0 105 044 ist ein Kontaktstift rechteckigen Querschnitts bekannt, dessen Einpreßzone aus einem in bezug auf den Schaft verbreiterten Mittelabschnitt durch Stanzprägen hergestellt wird. Hierbei werden mittels zweier Längsschnitte drei Federschenkel gebildet, von denen der mittlere in eine Richtung der Schnittebene und die anderen beiden in die entgegengesetzte Richtung ausgebogen sind. Die rückwärtigen Enden der beiden äußeren Federschenkel überlappen hierbei das entsprechende Ende des mittleren Federschenkels. Letzterer bildet somit einen Keil, der bei in einer Bohrung befestigtem Kontaktstift, von den beiden äußeren, eine V-förmige Lage einnehmenden Federschenkeln eingeklemmt wird. Diese Anordnung der drei Schenkel begrenzt jedoch ihre Federeigenschaften.

Weiterhin ist aus der DE-OS 25 45 505 ein Verfahren zur Herstellung eines Kontaktstiftes bekannt. Hier werden, wie in der EP-A-0 105 044 beschrieben, mittels Stanzpressen drei Federschenkel gebildet, von denen die beiden äußeren in einem zusätzlichen Arbeitsschritt noch so voneinander weg verdreht werden, daß alle drei dem Berührungseingriff mit einer Lochwandung dienenden Anlageflächen einen gleichmäßigen Abstand zueinander haben. Bei diesem Verdrehen erhalten die rückwärtigen Enden der Federschenkel eine Lage, in der sie aber nur noch einen geringen, die elastische Auslenkung der Federschenkel eng begrenzenden Abstand zueinander aufweisen.

Der Erfindung liegt die Aufgabe zugrunde, ein einfaches Werkzeug zur Herstellung von Kontaktstiften anzugeben, deren aus je drei Federschenkeln bestehende Einpreßzonen ohne zusätzliches Löten in durchkontaktierten Bohrungen befestigbar sind, die relativ große, von einem Normdurchmesser abweichende Toleranzen aufweisen. Diese Aufgabe wird erfindungsgemäß mit den im Anspruch 1 angegebenen konstruktiven Merkmalen gelöst. Vorteilhafte Merkmale der Erfindung sind den Unteransprüchen zu entnehmen.

Mit der Erfindung sind verschiedene Vorteile erzielbar. Die vollständige Fertigstellung von Kontaktstiften mit nur einem Werkzeug in einem Arbeitsgang ist äußerst wirtschaftlich. Durch die Anwendung des kombinierten Stanz- und Formpreßverfahrens können solche Kontaktstifte sehr preiswert angefertigt werden. Dies ist insofern von großem Nutzen, da es sich bei dem Kontaktstift um einen elektrotechnischen Massenartikel handelt, der insbesondere in Geräten von elektronischen Fernsprechsystemen in großen Stückzahlen verwendet wird.

Das Werkzeug besteht in vorteilhafter Weise aus nur zwei relativ einfachen Teilen, die eine hohe Standzeit haben. Andere Folgewerkzeuge werden zur Herstellung der Einpreßzone nicht benötigt. Der Stempel wird lediglich durch eine Absenk- und Hubbewegung gesteuert, die eine hohe Taktgeschwindigkeit erlauben. Die damit gefertigten Kontaktstifte können mit Preßsitz sicher in Bohrungen gedruckter Schaltungsplatten befestigt werden, wobei die 120° Anordnung ihrer Federschenkel darin eine gleichmäßige Druckverteilung auch bei Minustoleranzen der Bohrungen bewirkt. Der relativ große Federweg des zweiten und dritten Schenkels verhindert dabei durch elastisches Zurückweichen eine Beschädigung der Plattierung.

Die Erfindung wird anhand von Zeichnungen wie folgt näher erläutert. In den Zeichnungen zeigen:

Fig. 1    einen in die Bohrung einer gedruckten Schaltungsplatte eingesetzten Kontaktstift mit im Querschnitt dargestelltem Befestigungsabschnitt;

Fig. 2    einen Ausschnitt der aus Matrize und Stempel bestehenden Werkzeughälften mit den Befestigungsabschnitt eines Kontaktelementes formenden Werkzeugteilen, in einer Querschnittsansicht;

Fig. 3    den Ausschnitt eines Kontaktstiftes mit einem mittels des Werkzeuges nach Fig. 2 hergestellten Befestigungsabschnitt, von vorn gesehen;

Fig. 4 den Ausschnitt des Kontaktstiftes der Fig. 3, in der Seitenansicht.

In den Zeichnungen ist der vorzugsweise einen rechteckigen Querschnitt aufweisende elektrische Kontaktstift allgemein mit 1 bezeichnet. Er ist mit einem aufgeweiteten Mittelabschnitt zur elastischen Befestigung in der Bohrung 2 beispielsweise einer gedruckten Schaltungsplatte 3 versehen, deren Leitungszüge 4 sich bis in die Bohrung 2 erstrecken und in der sie die Bohrungswandung rohrförmig auskleiden.

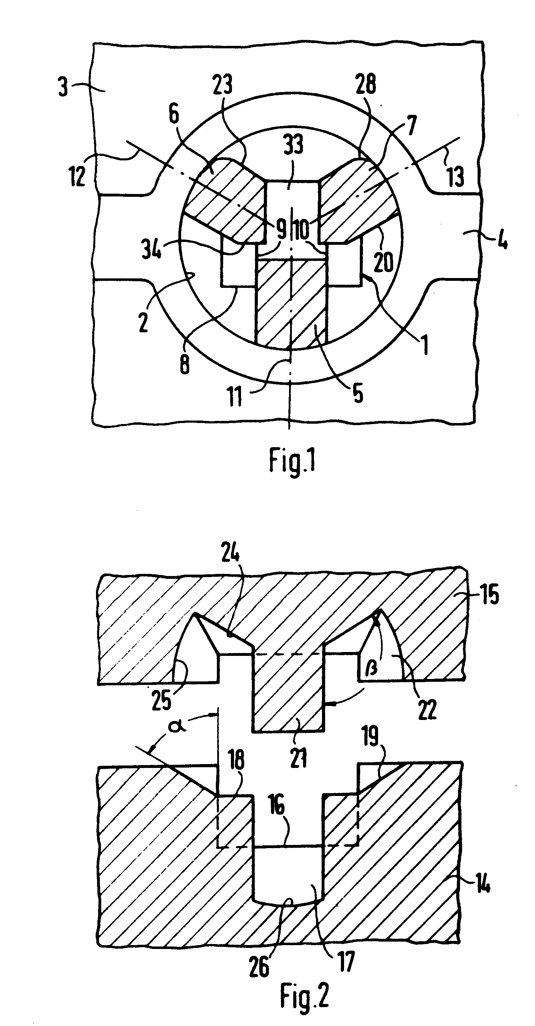

Wie insbesondere Fig. 1 zeigt, besteht der Mittelabschnitt des Kontaktstiftes 1 aus drei federnden Schenkeln 5, 6, 7, von denen ein erster Schenkel 5 auf einer Breitseite 8 des Kontaktstiftes 1 brückenartig ausgebogen ist. Dieser Schenkel 5 wird durch Stanzprägen hergestellt, bei dem zwei in parallelem Abstand zueinander verlaufende Längsschnitte 9, 10 den Kontaktstift 1 in Axialrichtung durchtrennen. Während des Stanzprägens wird mittels Fließpressen der zweite und dritte Schenkel 6, 7 gebildet, deren radiale Federungsachsen 12, 13 in einem Winkel von vorzugsweise 120° zur Federungsachse 11 des ersten Schenkels 5 stehen.

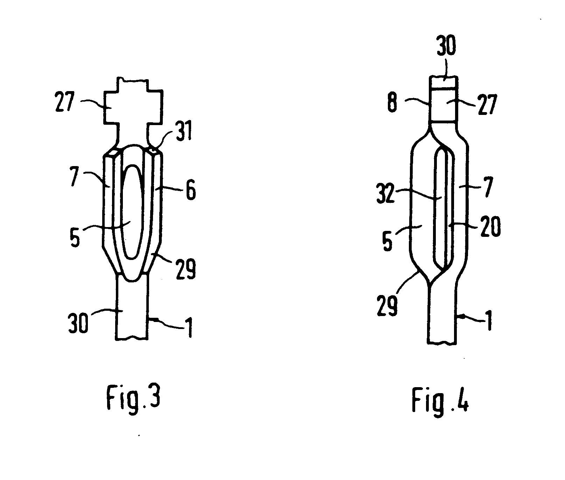

In Fig. 2 ist das zur Herstellung von Kontaktstiften 1 verwendete Werkzeug in Form einer Matrize 14 mit zugehörigem Stempel 15 dargestellt. Die Matrize 14 ist mit einer eine Auflagefläche 16 für den Kontaktstift 1 enthaltenden Aufnahme und mit einem wannenförmigen, mittig in die Auflagefläche 16 eingearbeiteten Schlitz 17 für die Herstellung des ersten Schenkels 5 versehen. Bei vorliegendem Ausführungsbeispiel entspricht das Maß der Schlitzbreite dem der halben Seitenlänge des Kontaktstiftschaftes. Von der Auflagefläche 16 aus erheben sich zu beiden Längsseiten des Schlitzes 17 je ein brückenartiger Vorsprung 18 mit einer einem Viertel der Seitenlänge des Kontaktstiftschaftes entsprechenden Breitenabmessung. Von den Oberflächen der Vorsprünge 18 aus erstreckt sich je eine zur Seite schräg ansteigende, an der Trennlinie der Werkzeughälften auslaufende Fläche 19, mittels derer je eine über den Kontaktstiftschaft hinausstehende Längsseite 20 von zweitem und drittem Schenkel 6, 7 geformt werden (Fig. 1 und 4). Die Flächen 19 sind jeweils in einem Winkel $\alpha$ von 60° zur Schließrichtung der Werkzeughälften angeordnet.

Bei der als Stempel 15 ausgebildeten Werkzeughälfte ist ein mit dem Schlitz 17 in der Matrize 14 zusammenwirkender, komplementärer Schneid- und Prägesteg 21 angeordnet. Dieser steht an der Trennlinie des Stempels 15 hervor und dringt beim Schließen der Werkzeughälften zum Teil in den Schlitz 17 der Matrize 14 ein. Neben beiden Längsseiten des Schneid- und Prägesteges 21 enthält diese Werkzeughälfte je eine Ausnehmung 22, in die hinein sich das beim Schließen der Werkzeughälften verdrängte Material ausbreitet. Zur Formung der zweiten Längsseite 23 von zweitem und drittem Schenkel 6, 7 des Kontaktstiftes 1 weisen die Ausnehmungen 22 ebenfalls je eine schräge Fläche 24 auf, die parallel zur entsprechenden Fläche 19 der Matrize 14 verlaufen, d.h. in einem Winkel $\beta$ von 120° zur Schließrichtung der Werkzeughälfte angeordnet sind. Bei geschlossenen Werkzeughälften haben die die Längsseiten 20, 23 von zweitem und drittem Schenkel 6, 7 formenden schrägen Flächen 19, 24 einen der Breite des Schlitzes 17 in der Matrize 14 entsprechenden Abstand zueinander. Vom äußeren Ende der schrägen Flächen 24 bis zur Trennlinie der Werkzeughälfte erstreckt sich je ein die Ausnehmungen 22 begrenzender gekrümmter Wandungsteil 25. Mit diesen Wandungsteilen 25 und dem entsprechenden Wandungsteil 26 am Boden des Schlitzes 17 der Matrize 14 werden die Außenflächen der drei Schenkel 5, 6, 7 des Kontaktstiftes 1 geformt, deren Radien dem Radius der Bohrung 2 in der gedruckten Schaltungsplatte 3 angepaßt sind. Daher liegen die Innenflächen der drei genannten Wandungteile 25, 26 bei geschlossenen Werkzeughälften auf einem Kreis, dessen Mittelpunkt mit der Längsachse des in der Aufnahme liegenden Kontaktstiftes 1 zusammenfällt. Der Durchmesser dieses Kreises ist jedoch etwas größer als der Bohrungsdurchmesser in der gedruckten Schaltungsplatte 3, welcher beispielsweise ein genormtes Maß von 1,5 mm hat.

Der Kontaktstift 1 wird in einem Arbeitsschritt aus Blech gestanzt und dabei so im Umriß freigeschnitten, daß er einen die Einsetztiefe begrenzenden Anschlag 27 erhält (Fig. 3). Beim Niedergehen des Stempels 15 wird gleichzeitig der die spätere Einpreßzone des Kontaktstiftes 1 bildende Mittelabschnitt hergestellt, wobei der erste Schenkel 5 gestanzt und seine gewölbte Außenfläche geprägt wird und wobei der zweite und der dritte Schenkel 6, 7 durch Fließpressen erzeugt werden, das eine transversale Materialverdrängung bewirkt. Weil die Ecken der Ausnehmungen 22 des Stempels 15 im Übergangsbereich zwischen den schrägen Flächen 24 und den gewölbten Wandungsteilen 25 dem Toleranzausgleich dienen und beim Fließpressen deshalb nicht vollständig mit Werkstoff ausgefüllt werden, erhalten die Schenkel 6, 7 eine gerundete Kante 28 (Fig. 1).

Wie Fig. 3 und 4 erkennen lassen, können die Ausformungen in Matrize 14 und Stempel 15 zur Herstellung der drei Schenkel 5, 6, 7 in der Weise unsymmetrisch ausgebildet sein, daß letztere an den zum Einpressen in eine Bohrung 2 der Schaltungsplatte 3 dienenden Enden 29 vom Schaft 30 des Kontaktstiftes 1 her relativ flach ansteigen, während die entgegengesetzten Enden 31 einen relativ steilen Anstieg aufweisen. Unabhängig davon werden die Schenkel 5, 6, 7 bei der Formung im Werkzeug vom Schaft 30 des Kontaktstiftes 1 aus so weit in entgegengesetzte Richtungen gepreßt, daß zwischem dem ersten Schenkel 5 und den beiden anderen Schenkeln 6, 7 ein Luftspalt 32 gebildet wird (Fig. 4).

Wird der Kontaktstift 1 in die Bohrung 2 einer Schaltungsplatte 3 eingesetzt, so bewegen sich seine Schenkel 5, 6, 7 radial nach innen. Hierbei verengen der zweite und dritte Schenkel 6, 7 den Raum 33, aus dem der erste Schenkel 5 gestanzt wurde (Fig. 1). Gleichzeitig verringert sich zwischen erstem Schenkel 5 und den beiden anderen Schenkeln 6, 7 die Breite des Luftspaltes 32, welcher sich bei einer im Durchmesser Minustoleranz aufweisenden Bohrung 2 gänzlich schließen kann. Da die zuvor von der Bohrungswandung nach innen gedrückten zweiten und dritten Schenkel 6, 7 ein Verkeilen des ersten Schenkels 5 zwischen ihnen verhindern, bleibt deren Federwirkung in vorteilhafter Weise auch in einem derartigen Befestigungsfall erhalten. Die sonst radial nach innen erfolgende Auslenkung von zweitem und dritten Schenkel 6, 7 wird in diesem Fall wegen der beim Stanzen von den Vorsprüngen 18 der Matrize 14 durchgedrückten Flächen 34 an ihren zum ersten Schenkel 5 weisenden Längsseiten lediglich in eine laterale Bewegungsrichtung umgelenkt. Es sei noch erwähnt, daß die an die Längsseiten 20 von zweitem und drittem Schenkel 6, 7 anschließenden Flächen 34 vor der Befestigung des Kontaktstiftes 1 mit der Längsachse seines Schaftes 30 in einer Ebene liegen und außerdem die Federungsachsen 11, 12, 13 aller Schenkel 5, 6, 7 die Längsachse des Schaftes 30 schneiden.

Anhand der Fig. 1 bis 4 ist die Herstellung von Kontaktstiften 1 für die lötlose Befestigung in Bohrungen 2 gedruckter Schaltungsplatten 3 beschrieben. Weil die freien Schäfte 30 der Kontaktstifte 1 als Anschlußpfosten für Drahtwickel und/oder als Steckerstifte dienen, haben die Schäfte 30 einen eckigen Querschnitt mit einer üblichen Seitenlänge von beispielsweise 0,8 × 1,0 mm. Natürlich können die mit Einpreßzonen versehenen Kontaktstifte auch einstückiger Bestandteil einer als Flachstecker ausgebildeten Kontaktbrücke sein, an der sie dem Lochraster der Schaltungsplatten 3 entsprechend, z.B. an zwei sich gegenüberliegenden Längsseiten eines Blechstreifens rechtwinklig abgebogen sind.

**Patentansprüche**

1. Werkzeug zur Herstellung eines elektrischen Kontaktstiftes (1) für gedruckte Schaltungsplatten (3), das aus zwei als Matrize (14) und Stempel (15) ausgeführten Werkzeughälften besteht, von denen die Matrize (14) eine Aufnahme für den Schaft (30) des Kontaktstiftes (1) und für die Herstellung des ersten Schenkels (5) einen in die Auflagefläche (16) der Aufnahme eingearbeiteten Schlitz (17) enthält, neben dem zum Durchdrücken des zweiten und dritten Schenkels (6, 7) auf jeder Längsseite ein sich von der Auflagefläche (16) aus erhebender Vorsprung (18) angeordnet ist, dessen Oberfläche in eine schräg nach außen gerichtete, an der Trennlinie des Werkzeuges auslaufenden Fläche (19) übergeht, und daß der Stempel (15) einen mit dem Schlitz (17) in der Matrize (14) korrespondierenden Schneid- und Prägestempel (21) zum Durchdrücken des ersten Schenkels (5) aufweist, neben dem auf jeder Längsseite zur Formung des zweiten bzw. dritten Schenkels (6, 7) je eine Ausnehmung (22) mit einer zur schrägen Fläche (19) der Matrize (14) parallelen Fläche (24) angeordnet ist.

2. Werkzeug nach Anspruch 1, dadurch gekennzeichnet, daß die beiden schrägen Flächen (19) der Matrize (14) jeweils in einem Winkel $\alpha$ von 60° und die beiden entsprechenden schrägen Flächen (24) des Stempels (15) jeweils in einem Winkel $\beta$ von 120° zur Schließrichtung der Werkzeughälften angeordnet sind.

3. Werkzeug nach Anspruch 1 oder 2 dadurch gekennzeichnet, daß die schrägen Flächen (19, 24) von Matrize (14) und Stempel (15) bei geschlossenen Werkzeughälften einen der Breite des Schlitzes (17) in der Matrize (14) entsprechenden Abstand zueinander aufweisen.

4. Werkzeug nach Anspruch 1 oder 3, dadurch gekennzeichnet, daß der Schlitz (17) in der Matrize (14) halb so breit ist wie die Aufnahme für den Schaft (39) des Kontaktstiftes 1.

5. Werkzeug nach einem der Ansprüche 1 bis 4, dadurch gekennzeichnet, daß die zwischen den Enden der schrägen Flächen (24) in den Ausnehmungen (22) des Stempels (15) bis zur Trennlinie dieser Werkzeughälfte verlaufenden Innenflächen der Wandungsteile (25) und der in der Matrize (14) den Boden des Schlitzes (17) bildende Wandungsteil (26) bei geschlossenen Werkzeughälften auf einem Kreis liegen, dessen Mittelpunkt mit der Längsachse des in der Aufnahme liegenden Kontaktstiftes (1) zusammenfällt.

**Claims**

1.  Die for producing an electric contact pin (1) for printed circuit boards (3), which die consists of two parts, a female part (14) and a male part (15), the female part (14) having a portion for receiving the shank (30) of the contact pin (1) and, in the bearing surface (16) of the receiving portion, a slot (17) for forming the first leg (5), beside which slot a projection (18) for forming the second and third legs (6, 7) rises from the bearing surface (16) on each long side, the surface of the projection (18) passing into an outwardly inclined surface (19) ending at the parting line of the die, and the male part (15) having a punch (21) corresponding to the slot (17) in the female part (14) for forming the first leg (5), beside which punch there is a recess (22) on each long side for forming the second leg (6) and the third leg (7), respectively, said recess (22) having a surface (24) parallel to the inclined surface (19) of the female part (14).

2.  A die as claimed in claim 1, characterized in that each of the two inclined surfaces (19) of the female part (14) makes an angle $\alpha$ of 60° with the direction of closure of the two parts of the die, and that each of the two corresponding inclined surfaces (24) of the male part (15) makes an angle $\beta$ of 120° with said direction.

3.  A die as claimed in claim 1 or 2, characterized in that, with the two parts of the die closed, the inclined surfaces (19, 24) of the female (14) and male (15) parts are separated by a distance equal to the width of the slot (17) in the female part (14).

4.  A die as claimed in claim 1 or 3, characterized in that the slot (17) in the female part (14) is half as wide as the portion for receiving the shank (30) of the contact pin (1).

5.  A die as claimed in any one of claims 1 to 4, characterized in that, with the two parts of the die closed, the surfaces of the wall portions (25) extending from the outer ends of the inclined surfaces (24) in the recesses (22) of the male part (15) to the parting line and the wall portion (26) forming the bottom of the slot (17) in the female part (14) lie on a circle whose center coincides with the longitudinal axis of the contact pin (1) lying in the receiving portion.

**Revendications**

1.  Outil pour la fabrication d'une broche électrique de contact (1) pour des plaquettes de circuit imprimé (3), composée de deux demi-outils réalisés sous la forme d'une matrice (14) et d'un poinçon (15), dont la matrice (14) comporte un logement pour la partie (30) en forme de tige de la broche de contact (1) et, pour la réalisation de la première branche (5), une fente (17) formée dans la surface d'appui (16) du logement et à côté de laquelle, pour réaliser le pressage de la deuxième et de la troisième branches (6, 7), est disposée, à partir de la surface d'appui (16) sur chaque face longitudinale, une partie en saillie dont la surface se prolonge par une surface (19) dirigée obliquement vers l'extérieur et débouchant sur la ligne de séparation de l'outil, et en ce que le poinçon (15) comporte une partie de découpe et d'estampage (21) qui correspond à la fente (17) de la matrice (14) et qui assure le formage par pressage de la première branche (5), et à côté de laquelle partie est disposé, de chaque côté longitudinal, un évidement (22) pour le formage de la deuxième ou de la troisième branche (6, 7) et qui comporte une surface (24) disposée parallèlement à la surface (19) inclinée de la matrice (14).

2.  Outil selon la revendication 1, caractérisé en ce que les deux surfaces inclinées (19) de la matrice (14) sont chacune disposées selon un angle a de 60° et les deux surfaces inclinées correspondantes (24) du poinçon (15) sont chacune disposées selon un angle $\beta$ de 120° par rapport à la direction de fermeture des demi-outils.

3.  Outil selon la revendication 1 ou 2, caractérisé en ce que les surfaces inclinées (19, 24) de la matrice (14) et du poinçon (15) sont disposées l'une par rapport à l'autre, quand les demi-outils sont fermés, à une distance correspondant à la largeur de la fente (17) dans la matrice (14).

4.  Outil selon la revendication 1 ou 3, caractérisé en ce que la largeur de la fente (17) de la matrice (14) est la moitié de la largeur du logement de la tige (39) de la broche de contact (1).

5.  Outil selon l'une des revendications 1 à 4, caractérisé en ce que les surfaces intérieures des parties de paroi (25) qui s'étendent entre les extrémités des surfaces inclinées (24) dans les logements (22) du poinçon (15) jusqu'à la ligne de séparation de ces demi-outils et la partie de paroi (26) qui constitue le fond de la fente (17) de la matrice (14), quand les demi-outils sont fermées, sont disposées sur un cercle dont le centre coïncide avec l'axe longitudinal de la broche de contact (1) se trouvant dans le logement.

Fig.1

Fig.2

Fig.3

Fig.4